# EUROPEAN PATENT APPLICATION

(11) **EP 2 671 925 A1**
(43) Date of publication of application: **11.12.2013**
(21) Application number: 12741977.8
(22) Date of filing: 31.01.2012
(51) Int. Cl.: C08L 101/00, H01L 21/52, H01L 23/36

(54) **RESIN COMPOSITION AND SEMICONDUCTOR DEVICE**

(30) Priority: 31.01.2011 JP 2011017747
(71) Applicant: Sumitomo Bakelite Co., Ltd., Shinagawa-ku Tokyo 140-0002 (JP)
(72) Inventor: MAKIHARA Kouji, Tokyo 140-0002 (JP); MURAYAMA Ryuichi, Tokyo 140-0002 (JP)
(74) Representative: Schnappauf, Georg
(86) International application number: PCT/JP2012/052132
(87) International publication number: WO 2012/105550

(57) **Abstract**

The invention provides a resin composition that is excellent in terms of coating workability and can supply reliability, including the soldering reflow resistance, to a semiconductor device when being used as a die attach material or an adhesive for a heat dissipation member. The resin composition of the invention contains a polymer or copolymer of a conjugated diene compound having at least one functional group, a thermosetting resin and a (meth)acryl polymer or copolymer having a reactive functional group that can react with other reactive groups.

## Description

### Technical Field

The present invention relates to a resin composition and a semiconductor device.
Priority is claimed on Japanese Patent Application No. 2011-017747, filed January 31, 2011, the content of which is incorporated herein by reference.

### Background Art

In recent years, attempts have been made to eliminate lead from a semiconductor product as a response to environmental concerns, and thus, a lead-free solder has been used when mounting a semiconductor package on a substrate. In a case in which such lead-free solder is used, the reflow soldering temperature increases compared to a case in which a tin-lead solder of the related art is used. Therefore, for a die attach material that attaches a semiconductor element, such as an 1C, to a support, such as a metal frame or an organic substrate, there has been a demand to be more resistant to detachment during reflow soldering, that is, a capability that can sufficiently endure an increase of an internal stress in a semiconductor package which is caused by an increase in the reflow soldering temperature, and it has become important to exhibit an excellent low stress property and high adhesiveness at a high temperature.

In order to meet the above demand for an excellent low stress property and high adhesiveness at a high temperature, a method, in which a stress reducer, such as liquid rubber, is added for the purpose of giving a low stress property to a cured die attach material (for example, refer to Patent Document 1), is being studied. However, in this method, particularly in a case in which a low-polarity liquid rubber is used, there was a problem in that the liquid rubber was separated while being stored due to its poor compatibility with other resins, and, consequently, the coating stability or curing property may be deteriorated.

Therefore, in order to solve the above problem, studies are made regarding a method in which a polymer or copolymer of a butadiene compound having a functional group, such as a vinyl group, an epoxy group, a carboxyl group, a hydroxyl group or a maleic acid group, is used, and a resin composition that is excellent in terms of coating workability and soldering crack resistance has been invented (for example, refer to Patent Document 2). However, while the compatibility of the liquid rubber with other resins becomes favorable, since the polymer or copolymer of the butadiene compound contains the functional group, the viscosity of the raw material increases. In a case in which such a raw material was used in the die attach material, when the raw material was added until favorable soldering crack resistance was exhibited, the viscosity of the resin composition increased, and the deterioration of coating workability, such as failed thread cutting property, was caused. In spite of an increasing demand for an improvement in the performance of a die attach material for an additional improvement in the performance of a semiconductor package, there has been no die attach material that satisfies soldering crack resistance and coating workability at the same time, and there has been a desperate demand for a die attach material that satisfies both soldering reflow resistance and coating workability at a high level.

### Citation List

### Patent Documents

[Patent Document 1] Japanese Unexamined Patent Application, First Publication No. 2005-154633
[Patent Document 2] Japanese Unexamined Patent Application, First Publication No. 2010-47696

### Summary of Invention

### Technical Problem

An object of the invention is to provide a resin composition that is excellent in terms of coating workability and can enhance reliability, including the soldering reflow resistance of a semiconductor device, when being used as a die attach material or an adhesive for a heat dissipation member.

### Solution to Problem

The above object is achieved using the invention described in the following [1] to [14].
[1] A resin composition containing (A) a polymer or copolymer of a conjugated diene compound having at least one functional group, (B) a thermosetting resin and (C) a (meth)acryl polymer or copolymer, in which the (C) (meth)acryl polymer or copolymer has a reactive functional group that can react with other reactive groups.
[2] The resin composition according to [1], in which the (C) (meth)acryl polymer or copolymer has a reactive functional group that can react with the functional group included in the (A) polymer or copolymer of a conjugated diene compound having at least one functional group.
[3] The resin composition according to [2], in which the (A) component is a polymer or a copolymer of butadiene.
[4] The resin composition according to [2] or [3], in which the functional group included in the (A) component is at least one selected from a group consisting of a vinyl group, a (meth)allyl group, a (meth)acryloyl group, an epoxy group, a carboxyl group, a hydroxyl group and a maleic anhydride group.
[5] The resin composition according to any one of [2] to [4], in which the (B) component is at least one selected from a group consisting of a cyanate resin, an epoxy resin, an acryl resin and a maleimide resin.
[6] The resin composition according to any one of [2] to [5], in which the reactive function group of the (C) component is at least one selected from a group consisting of a vinyl group, a (meth)allyl group, a (meth)acryloyl group, a maleimide group, an epoxy group, a carboxyl group and a hydroxyl group.
[7] The resin composition according to any one of [2] to [6], in which the (A) component is included at 1 weight% to 20 weight%, and the (C) component is included at 0.5 weight% to 25 weight% with respect to the total weight of the resin composition.
[8] The resin composition according to [1], in which the (C) (meth)acryl polymer or copolymer has a reactive functional group that can react with the functional group included in the (B) thermosetting resin.
[9] The resin composition according to [8], in which the (A) component is a polymer or a copolymer of butadiene.
[10] The resin composition according to [8] or [9], in which the functional group included in the (A) component is at least one selected from a group consisting of a vinyl group, a (meth)allyl group, a (meth)acryloyl group, an epoxy group, a carboxyl group, a hydroxyl group and a maleic anhydride group.
[11] The resin composition according to any one of [8] to [10], in which the (B) component is at least one selected from a group consisting of a cyanate resin, an epoxy resin, an acryl resin and a maleimide resin.
[12] The resin composition according to any one of [8] to [11], in which the reactive function group of the (C) component is at least one selected from a group consisting of a vinyl group, a (meth)allyl group, a (meth)acryloyl group, a maleimide group, an epoxy group, a carboxyl group and a hydroxyl group.
[13] The resin composition according to any one of [8] to [12], in which the (A) component is included at 1 weight% to 20 weight%, and the (C) component is included at 0.5 weight% to 25 weight% with respect to a total weight of the resin composition.
[14] A semiconductor device manufactured using the resin composition according to any one of [1] to [13] as a die attach material or an adhesive material for a heat dissipation member.

### Advantageous Effects of Invention

The resin composition of the invention is excellent in terms of coating workability, and enables the obtainment of a semiconductor device having excellent reliability by being used as a die attach material for one of a semiconductor and an adhesive for a heat dissipation member.

### Description of Embodiments

The invention is a resin composition containing a polymer or copolymer of a conjugated diene compound having at least one functional group (A), a thermosetting resin (B) and a (meth)acryl polymer or copolymer (C), in which the (meth)acryl (co)polymer (C) has a reactive functional group that can react with other reactive groups. Particularly, the (meth)acryl (co)polymer (C) can have a reactive functional group that can react with at least any one of the functional groups included in the (co)polymer of a conjugated diene compound (A) or thermosetting resin (B). In addition, since the above characteristics lead to excellent coating workability and the exhibition of favorable low stress property and high adhesiveness at a high temperature, when the invention is used as a die attach material for a semiconductor or an adhesive for a heat dissipation member, it becomes possible to provide a semiconductor device having an unprecedentedly high reliability.
Meanwhile, in the invention, the polymer or copolymer of a diene-based compound (A) and the (meth)acryl polymer or copolymer (C) will also be collectively described as the (co)polymer (A) and the (co)polymer (C) respectively.
Hereinafter, the invention will be described in detail.

The polymer or copolymer of a conjugated diene compound having at least one functional group (A), used in the invention, is used for the purpose of giving toughness or low stress property to the cured resin composition. The use of the (co)polymer (A) makes the cured resin composition exhibit a low elastic modulus and a high adhesiveness at a high temperature, which further prevents the occurrence of detachment. The (co)polymer (A) has a functional group for the main purpose of enhancing the compatibility with other resins, and specific examples of the functional group include a vinyl group, a (meth)allyl group, a (meth)acryloyl group, an epoxy group, a carboxyl group, a hydroxyl group, a maleic anhydride group and the like. Among the above functional groups, the (co)polymer (A) having one of a maleic anhydride group, an epoxy group and a carboxyl group is preferably used particularly because the compatibility with other resins becomes favorable, and a resin composition having excellent coating workability can be obtained. In addition, the functional groups can also be used in a curing reaction in order to further improve the cohesive force of a cured resin composition.

The polymer of the conjugated diene compound used in the invention is preferably a polymer, such as butadiene or isoprene, and the copolymer of the conjugated diene compound is preferably a copolymer of a conjugated diene compound, such as butadiene or isoprene, and at least one selected from acrylic acid ester, acrylonitrile and styrene. Among the above, a polymer or copolymer using butadiene is particularly preferable as the conjugated diene compound since a polymer or copolymer having a low viscosity can be obtained. Furthermore, in the polymer or copolymer of butadiene, in a case in which attention is paid to the microstructure, the fraction of 1,4 vinyl bonds with respect to the sum of 1,4 vinyl bonds and 1,2 vinyl bonds is preferably 50% or more, and more preferably 60% to 85%. This is because a polymer or copolymer of a butadiene compound having a large fraction of 1,4 vinyl bonds is excellent in terms of low stress property, and, furthermore, has a low viscosity, and therefore the polymer or copolymer works advantageously even in terms of the workability of the resin composition.

The molecular weight of the (co)polymer (A) used in the invention is preferably a number-average molecular weight of 1000 to 20000, and more preferably a number-average molecular weight of 2000 to 15000. When the molecular weight is set to the lower limit value or more of the above range, it is possible to develop a more favorable low stress property. In addition, when the molecular weight is set to the upper limit value or less of the above range, it is possible to obtain a more favorable coating workability.

The thermosetting resin (B) used in the invention is a component that contributes to the heat resistance or adhesiveness of a cured resin composition, and is not particularly limited as long as a 3-dimensional network structure can be formed through heating, and examples thereof include a cyanate resin, an epoxy resin, an acryl resin, a maleimide resin and the like. Since the thermosetting resin can form a resin composition, the thermosetting resin is preferably a liquid resin at room temperature in a form of either a single element or a mixture.

In a case in which the thermosetting resin (B) used in the invention is a cyanate resin, the cyanate resin refers to a compound having a -NCO group in the molecule, and a compound that can form a 3-dimensional network structure and can be cured when the -NCO group is reacted through heating. Specific examples of the cyanate resin include 1,3-dicyanate benzene, 1,4-dicyanate benzene, 1,3,5-tricyanate benzene, 1,3-dicyanate naphthalene, 1,4-dicyanate naphthalene, 1,6-dicyanate naphthalene, 1,8-dicyanate naphthalene, 2,6-dicyanate naphthalene, 2,7-dicyanate naphthalene, 1,3,6-tricyanate naphthalene, 4,4'-dicyanate biphenyl, bis(4-cyanatephenyl)methane, bis(3,5-dimethyl-4-cyanate phenyl)methane, 2,2-bis(4-cyanatephenyl)propane, 2,2-bis(3,5-dibromo-4-cyanatephenyl)propane, bis(4-cyanatephenyl)ether, bis(4-cyanatephenyl)thioether, bis(4-cyanatephenyl)sulfone, tris(4-cyanatephenyl)phosphide, tris(4-cyanatephenyl)phosphate, cyanates obtained from a reaction between a novolak resin and a cyanogen halide, and the like, and it is also possible to use a prepolymer having a triazine ring formed by trimerizing the cyanate group in the polyfunctional cyanate resin. The prepolymer can be obtained by polymerizing monomers of the polyfunctional cyanate resin using, for example, an acid, such as a mineral acid or Lewis acid; a base, such as sodium alcoholate or a tertiary amine; or a salt, such as sodium carbonate, as a catalyst.

In a case in which the cyanate resin is used, generally, a curing accelerator is used together. A generally well-known curing accelerator can be used as the curing accelerator of the cyanate resin, and examples thereof include organic metal complexes, such as zinc octylate, tin octylate, cobalt naphthenate, zinc naphthenate and iron acetylacetone; metal salts, such as aluminum chloride, tin chloride and zinc chloride; and amines, such as triethylamine and dimethylbenzylamine, but the curing accelerator is not limited thereto. The curing accelerator can be used solely or in a mixture of two or more accelerators.
In addition, the cyanate resin can also be used jointly with other resins, such as an epoxy resin, an oxetane resin, an acryl resin or a maleimide resin.

In a case in which the thermosetting resin (B) used in the invention is an epoxy resin, the epoxy resin refers to a compound having one or more glycidyl groups in the molecule, and a compound that can form a 3-dimensional network structure and can be cured when the glycidyl group is reacted through heating. Two or more glycidyl groups are preferably included in a molecule, which is because, in a compound having only one glycidyl group, even after the glycidyl group is reacted, sufficient characteristics of a cured compound cannot be obtained. Examples of a compound having two or more glycidyl groups in a molecule include bifunctional compounds obtained by epoxidizing a bisphenol compound, such as bisphenol A, bisphenol F or bisphenol, or a derivative thereof, a diol having an alicyclic structure, such as hydrogenated bisphenol A, hydrogenated bisphenol F, hydrogenated bisphenol, cyclohexanediol, cyclohexanedimethanol or cyclohexanediethanol, or a derivative thereof, an aliphatic diol, such as butanediol, hexanediol, octanediol, nonanediol or decanediol, or a derivative thereof, or the like; trifunctional compounds having a trihydroxy phenylmethane skeleton or an aminophenol skeleton; polyfunctional compounds obtained by epoxidizing a phenol aralkyl resin, such as a phenol novolak resin, a cresol novolak resin, a phenol aralkyl resin having a phenylene skeleton or a biphenylene skeleton or a naphthol aralkyl resin having a phenylene skeleton or a biphenylene skeleton; and the like, but the compound is not limited thereto. In addition, it is also possible to use a reactive diluent in order for the adjustment of the viscosity of the resin composition, the adjustment of the crosslinking density of a cured compound, and the like. Examples of the reactive diluent include monofunctional aromatic glycidyl ethers, such as phenyl glycidyl ethers and cresyl glycidyl ethers, aliphatic glycidyl ethers, and the like.

In a case in which an epoxy resin is used, generally, a curing agent is used for the purpose of curing the epoxy resin. Examples of the curing agent of the epoxy resin include aliphatic amines, aromatic amines, dicyandiamide, dihydrazide compounds, acid anhydrides, phenol resins and the like.
Specific examples of the dihydrazide compounds include carboxylic acid dihydrazides, such as adipic acid dihydrazide, dodecanoic acid dihydrazide, isophthalic acid dihydrazide and p-oxybenzoic acid dihydrazide, and the like. In addition, specific examples of the acid anhydrides include phthalic anhydrides, tetrahydrophthalic anhydrides, hexahydrophthalic anhydrides, endomethylene tetrahydrophthalic anhydrides, dodecenyl succinic anhydrides, and the like. Meanwhile, in a case in which the phenol resin is used as the curing agent of the epoxy resin, the phenol resin is preferably a compound having two or more phenolic hydroxyl groups in a molecule. This is because, in a case in which the number of the phenolic hydroxyl group included in a molecule is one, it is not possible to obtain a crosslinking structure from a reaction with the epoxy resin, and the characteristics of a cured compound deteriorate. While the phenol resin can be used as long as the number of the phenolic hydroxyl groups in a molecule is two or more, but a preferable number of the phenolic hydroxyl group is 2 to 5. In a case in which the number of the phenolic hydroxyl group is larger than the above, since the molecular weight of the phenol resin becomes large, the viscosity of the resin increases, and the viscosity of a resin composition to be obtained also increases, which is not preferable. A more preferable number of the phenolic hydroxyl groups in a molecule is 2 or 3. Examples of the above compound include bisphenols, such as bisphenol F, bisphenol A, bisphenol S, tetramethyl bisphenol A, tetramethyl bisphenol F, tetramethyl bisphenol S, dihydroxy diphenyl ether, dihydroxy benzophenone, tetramethyl biphenol, ethylidene bisphenol, methylethylidene bis(methylphenol), cyclohexylidene bisphenol, biphenol, and derivatives thereof; trifunctional phenols, such as tri(hydroxyphenyl)methane, tri(hydroxyphenyl)ethane, and derivatives thereof; compounds obtained from a reaction between a formaldehyde and a phenol such as phenol novolak or cresol novolak, which are made up mainly of two-nucleus bodies or three-nucleus bodies, and derivatives thereof; and the like.

In a case in which the epoxy resin is used, in addition to the curing agent, a curing accelerator is used together frequently. Examples of the curing accelerator for the epoxy resin include salts of a conjugated slat group (anion that discharges proton) of an organic acid, such as imidazoles, triphenyl phosphine or tetra-substituted phosphonium and carboxylic acid, and phenols; amine-based compounds, such as diazabicycloundecene, and salts thereof; and the like, and imidazole compounds, such as 2-methylimidazole, 2-ethylimidazole 2-phenylimidazole, 2-phenyl-4-methylimidazole, 2-phenyl-4-methyl-5-hydroxymethylimidazole, 2-phenyl-4,5-dihydroxy methylimidazole, 2-C₁₁H₂₃-imidazole and adducts of 2-methylimidazole and 2,4-diamino-6-vinyltriazine, are preferably used. Among the above, imidazole compounds having a melting point of 180°C or higher are particularly preferable. In addition, the epoxy resin is preferably used together with a cyanate resin, an acrylic resin or a maleimide resin.

In a case in which the thermosetting resin (B) used in the invention is an acrylic resin, the acrylic resin refers to a compound having a radical polymerizable (meth)acryloyl group in the molecule, and a compound that can form a 3-dimensional network structure and can be cured when the (meth)acryloyl group is reacted. The acrylic resin needs to include one or more (meth)acryloyl groups in the molecule, and preferably includes two or more (meth)acryloyl groups in terms of the formation of a 3-dimensional network structure. Examples of the compound having the radical polymerizable (meth)acryloyl group include (meth)acrylates having a hydroxyl group, such as 2-hydroxyethyl(meth)acrylate, 2-hydroxypropyl(meth)acrylate, 3-hydroxypropyl(meth)acrylate, 2-hydroxybutyl(meth)acrylate, 3-hydroxybutyl(meth)acrylate, 4-hydroxybutyl(meth)acrylate, 1,2-cyclohexanediol mono(meth)acrylate, 1,3-cyclohexanediol mono(meth)acrylate, 1,4-cyclohexanediol mono(meth)acrylate, 1,2-cyclohexanedimethanol mono(meth)acrylate, 1,3-cyclohexanedimethanol mono(meth)acrylate, 1,4-cyclohexanedimethanol mono(meth)acrylate, 1,2-cyclohexanediethanol mono(meth)acrylate, 1,3-cyclohexanediethanol mono(meth)acrylate, 1,4-cyclohexanemdiethanol mono(meth)acrylate, glycerin mono(meth)acrylate, glycerin di(meth)acrylate, trimethylolpropane mono(meth)acrylate, trimethylolpropane di(meth)acrylate, pentaerythritol mono(meth)acrylate, pentaerythritol di(meth)acrylate, pentaerythritol tri(meth)acrylate and neopentyl glycol mono(meth)acrylate; (meth)acrylates having a carboxyl group obtained by reacting the (meth)acrylate having a hydroxyl group and a dicarboxylic acid or a derivative thereof; and the like. Examples of the dicarboxylic acid that can be used include oxalic acid, malonic acid, succinic acid, glutaric acid, adipic acid, pimelic acid, suberic acid, azelaic acid, sebacic acid, maleic acid, fumaric acid, phthalic acid, tetrahydrophthalic acid, hexahydrophthalic acid and derivatives thereof.

In addition to the above, specific examples include methyl(meth)acrylate, ethyl(meth)acrylate, n-butyl(meth)acrylate, isobutyl(meth)acrylate, tert-butyl(meth)acrylate, isodecyl(meth)acrylate, lauryl(meth)acrylate, tridecyl(meth)acrylate, cecyl(meth)acrylate, stearyl(meth)acrylate, isoamyl(meth)acrylate, isostearyl(meth)acrylate, behenyl(meth)acrylate, 2-ethylhexyl(meth)acrylate, other alkyl(meth)acrylates, cyclohexyl(meth)acrylate, ter-butyl cyclohexyl(meth)acrylate, tetrahydrofurfuryl(meth)acrylate, benzyl(meth)acrylate, phenoxyethyl(meth)acrylate, isobonyl(meth)acrylate, glycidyl(meth)acrylate, trimethylolpropane tri(meth)acrylate, zinc mono(meth)acrylate, zinc di(meth)acrylate, dimethylaminoethyl(meth)acrylate, diethylaminoethyl(meth)acrylate, neopentylglycol(meth)acrylate, trifluoroethyl(meth)acrylate, 2,2,3,3-tetrafluoropropyl(meth)acrylate, 2,2,3,3,4,4-hexafluorobutyl(meth)acrylate, perfluorooctyl(meth)acrylate, perfluorooctylethyl(meth)acrylate, ethylene glycol di(meth)acrylate, propylene glycol di(meth)acrylate, 1,4-butandiol di(meth)acrylate, 1,6-hexanediol di(meth)acrylate, 1,9-nonanediol di(meth)acrylate, 1,3-butanediol di(meth)acrylate, 1,10-decandiol di(meth)acrylate, tetraethylene glycol di(meth)acrylate, methoxyethyl (meth)acrylate, butoxyethyl (meth)acrylate, methoxyethyl (meth)acrylate, butoxyethyl (meth)acrylate, ethoxy diethylene glycol (meth)acrylate, methoxy polyalkylene glycol mono(meth)acrylate, octoxy polyalkylene glycol mono(meth)acrylate, lauroxypolyalkylene glycol mono(meth)acrylate, stearoxypolyalkylene glycol mono(meth)acrylate, allyloxypolyalkylene glycol mono(meth)acrylate, nonylphenoxy polyalkylene glycol mono(meth)acrylate, N,N'-methylene bis(meth)acrylamide, N,N'-ethylene bis(meth)acrylamide, 1,2-di(meth)acrylamide ethylene glycol, di(meth)acryloyloxy methyltricyclodecane, N-(meth)acryloyloxy ethylmaleimide, N-(meth)acryloyloxy ethyl hexa hydrophthalimide, N-(meth)acryloyloxy ethylphthalimide, N-vinyl-2-pyrrolidone, ethoxylated bisphenol A (meth)acrylate, propoxylated bisphenol A (meth)acrylate, styrene derivatives, α-methylstyrene derivatives, reaction products between polyether polyol and (meth)acrylic acid or a derivative thereof, reaction products between polyester polyol and (meth)acrylic acid or a derivative thereof, reaction products between polycarbonate polyol and (meth)acrylic acid or a derivative thereof, and the like. The compound having a (meth)acryloyl group can be used solely, or two or more compounds can be jointly used in order to adjust the cohesive force of a cured resin composition. In addition, the radical polymerizable acrylic resin is also preferably used together with a cyanate resin, an epoxy resin or a maleimide resin.

In a case in which the radical polymerizable acrylic resin is used, generally, a polymerization initiator is used together in order to initiate the polymerization reaction of the acrylic resin. A thermal radical polymerization initiator is preferably used as the polymerization initiator. The thermal radical polymerization initiator is not particularly limited as long as the thermal radical polymerization initiator is an ordinarily used initiator, but is desirably an initiator having a decomposition temperature of 40°C to 140°C in a rapid heating test (the kick-off temperature when a specimen of 1 g is placed on a electric hot plate, and heated at 4°C/minute). When the decomposition temperature is lower than 40°C, the storing property of the resin composition at room temperature becomes poor, and, when the decomposition temperature exceeds 140°C, the curing time becomes extremely long, which is not preferable. Specific examples of the thermal radical polymerization initiator that satisfies the above conditions include methyl ethyl ketone peroxide, methyl cyclohexanone peroxide, methyl acetoacetate peroxide, acetylacetone peroxide, I, 1-bis(t-butylperoxide)3,3,5-trimethylcyclohexane, 1,1-bis(t-hexylperoxy)cyclohexane, 1,1-bis(t-hexylperoxy)3,3,5-trimethylcyclohexane, 1,1-bis(t-butylperoxy)cyclohexane, 2,2-bis(4,4-di-t-buylperoxycyclohexyl)propane, 1,1-bis(t-butylperoxy)cyclododecane, n-butyl4,4-bis(t-butylperoxy)valerate, 2,2-bis(t-butylperoxy)butane, 1,1-bis(t-butylperoxy)-2-methylcyclohexane, t-butyl hydroperoxide, P-menthane hydroperoxide, 1,1,3,3-tetramethylbutyl hydroperoxide, t-hexyl hydroperoxide, dicumylperoxide, 2,5-dimethyl-2,5-bis(t-butylperoxy)hexane, α,α'-bis(t-butylperoxy)diisopropylbenzene, t-butylcumylperoxide, di-t-butylperoxide, 2,5-dimethyl-2,5-bis(t-butylperoxy)hexine-3, isobutyryl peroxide, 3,5,5-trimethylhexanoyl peroxide, octanoyl peroxide, lauroyl peroxide, cinnamic peroxide, m-toluoyl peroxide, benzoyl peroxide, diisopropyl peroxydicarbonate, bis(4-t-butylcyclohexyl)peroxydicarbonate, di-3-methoxybutyl peroxydicarbonate, di-2-ethylhexyl peroxydicarbonate, di-sec-butyl peroxydicarbonate, di(3-methyl-3-methoxybutyl)peroxydicarbonate, di(4-t-butylcyclohexyl)peroxydicarbonate, α,α'-bis(neodecanoyl peroxy)diisopropylbenzene, cumyl peroxyneodecanoate, 1,1,3,3,-tetramethylbutyl peroxyneodecanoate, 1-cyclohexyl-1-methyl ethyl peroxyneodecanoate, t-hexyl peroxyneodecanoate, t-butyl peroxyneodecanoate, t-hexyl peroxypivalate, t-butyl peroxypivalate, 2,5-dimethyl-2,5-bis(2-ethylhexanoyl peroxy)hexane, 1,1,3,3-tetramethylbutyl peroxy-2-ethylhexanoate, 1-cyclohexyl-1-methyl ethyl peroxy-2-ethyl hexanoate, t-hexylperoxy-2-ethylhexanoate, t-butylperoxy-2-ethylhexanoate, t-butylperoxy isobutyrate, t-butylperoxymaleic acid, t-butylperoxy laurate, t-butylperoxy-3,5,5-trimethylhexanoate, t-butylperoxy isopropyl monocarbonate, t-butylperoxy-2-ethylhexyl monocarbonate, 2,5-dimethyl-2,5-bis(benzoylperoxy)hexane, t-butylperoxy acetate, t-hexyl peroxy benzoate, t-butyl peroxy-m- toluoyl benzoate, t-butylperoxy benzoate, bis(t-butylperoxy)isophthalate, t-butylperoxyallyl monocarbonate, 3,3',4,4'-tetra(t-butyl peroxycarbonyl)benzophenone and the like, and the thermal radical polymerization initiator can be used solely, or two or more thermal radical polymerization initiators can be jointly used in order to control the curing property. The amount of the polymerization initiator blended is preferably 0.02 weight% to 5 weight%, and more preferably 0.05 weight% to 2 weight% in the resin composition from the viewpoint of the obtainment of a cured resin composition that is excellent in terms of curing property and thermal resistance.
Here, since the resin composition of the invention is ordinarily used under illumination of a fluorescent lamp or the like, when a photopolymerization initiator is included, an increase in the viscosity of the resin composition is observed due to a reaction while being used. Therefore, substantially, the inclusion of a photopolymerization initiator is not preferable. Substantially, a photopolymerization may be included as little as an increase in the viscosity is not observed, and is preferably not included.

In a case in which the thermosetting resin (B) used in the invention is a maleimide resin, the maleimide resin refers to a compound having one or more maleimide groups in the molecule, and a compound that can form a 3-dimensional network structure and can be cured when the maleimide group is reacted through heating. Examples thereof include bismaleimide resins, such as N,N'-(4,4'-diphenylmethane)bismaleimide, bis(3-ethyl-5-methyl-4-maleimidephenyl)methane and 2,2-bis[4-(4-maleimidephenoxy)phenyl]propane. The maleimide resin is more preferably a compound obtained from a reaction between a dimer acid diamine and a maleic acid anhydride and a compound obtained from a reaction between a maleimidized amino acid, called maleimide acetate and maleimide caproic acid, and a polyol. The maleimidized amino acid is obtained by reacting a maleic acid anhydride and amino acetate or amino caproic acid. The polyol is preferably polyether polyol, polyester polyol, polycarbonate polyol or poly(meth)acrylate polyol, and particularly preferably a polyol not including an aromatic ring. The maleimide resin is also preferably used together with the cyanate resin, the epoxy resin and the acrylic resin. In addition, since the maleimide group can react with an allyl group, the maleimide resin is also preferably used together with a compound having an allyl group, such as an allyl ester resin. The allyl ester resin is preferably one of aliphatic allyl ester resins, and, among the above, is particularly preferably a compound obtained from the ester exchange between cyclohexane diallyl ester and an aliphatic polyol.

The (meth)acryl polymer or copolymer (C) used in the invention is used for the purpose of giving low stress property and high adhesiveness to a cured resin composition. The use of the (co)polymer (C) makes the cured resin composition exhibit a low elastic modulus and a high adhesiveness at a high temperature, which further prevents the occurrence of detachment. The (co)polymer (C) has a reactive functional group that can react with at least any one of functional groups included in at least the (co)polymer (A) or the thermosetting resin (B), which is because a cured resin composition having a superior cohesive force is obtained. In a case in which the reactive functional group of the (co)polymer (C) does not react with any of the functional groups included in the (co)polymer (A) and the thermosetting resin (B), the cohesive failure of a cured resin composition is caused in the soldering crack resistance test, which is not preferable. Examples of the reactive functional group included in the (co)polymer (C) include a vinyl group, a (meth)allyl group, a (meth)acryloyl group, a maleimide group, an epoxy group, a carboxyl group, a hydroxyl group and the like. The (co)polymer (C) having a (meth)acryloyl group, an epoxy group, a hydroxyl group or a carboxyl group among the above functional groups is particularly preferably used from the viewpoint of storing property and reactivity.

The molecular weight of the (co)polymer (C) used in the invention is preferably a weight-average molecular weight of 1000 to 20000, more preferably a weight-average molecular weight of 1000 to 15000 and most preferably a weight-average molecular weight of 2000 to 15000. When the molecular weight is set to the lower limit value or more of the above range, it is possible to develop a more favorable low stress property. In addition, when the molecular weight is set to the upper limit value of the above range, it is possible to obtain a more favorable coating workability.

The method for manufacturing the (co)polymer (C) used in the invention is not particularly limited, and the (co)polymer can be manufactured by, for example, polymerizing or copolymerizing methyl ethyl butyl cyclohexyl (meth)acrylate, styrene, hydroxyethyl (meth)acrylic acid, glycidyl (meth)acrylate or the like using a well-known technique using an ordinary polymerization initiator and an ordinary chain transfer agent, such as solution polymerization. At this time, a manufacturing method, in which a reaction is caused at a high temperature and a high pressure, preferably with the concentration of the polymerization initiator and the chain transfer agent set to 1 weight% or less with respect to all components used in the reaction, more preferably with little use of the polymerization initiator and the chain transfer agent, and still more preferably with no use of the polymerization initiator and the chain transfer agent, is used. Thereby, the (co)polymer having a low molecular weight and a narrow molecular weight distribution can be obtained. The resin composition, in which the above (co)polymer is used, has advantages that the increase in the viscosity caused by the addition of the (co)polymer is small, and the stability of the cured resin composition is excellent at a high temperature. Such a (co)polymer is being sold with a product name of ARUFON by Toagosei Co., Ltd..

Among the (co)polymers (C), the (co)polymer (C) having a vinyl group, a (meth)allyl group, a (meth)acryloyl group or a maleimide group can be obtained by, for example, obtaining a (co)polymer having a carboxyl group, and then reacting the (co)polymer with a compound having a functional group that can react with a carboxyl group, such as hydroxyethyl (meth)acrylate, hydroxyl ethyl vinyl ether or (meth)allyl alcohol; or obtaining a (co)polymer having a glycidyl group, and then reacting the (co)polymer with a compound having a functional group that can react with a glycidyl group, such as a (meth)acrylic acid, a maleimidized amino acid or a derivative thereof.

In the resin composition of the invention, regarding the blending amount between the (co)polymer (A) of the diene compound and the (meth)acryl (co)polymer (C), it is preferable to set the (co)polymer (A) in the resin composition to 1 weight% to 20 weight% and the (co)polymer (C) to 0.5 weight% to 25 weight%, more preferable to set the (co)polymer (A) to 0.5 weight% to 20 weight% and the (co)polymer (C) to 0.5 weight% to 20 weight%, and still more preferable to set the (co)polymer (A) to 0.5 weight% to 12 weight% and the (co)polymer (C) to I weight% to 15 weight%. When the blending amount of the (co)polymer (A) and the (co)polymer (C) is set to the lower limit value or more, it is possible to make toughness, low stress property and adhesiveness more preferable, and, consequently, it is possible to decrease detachment under a high-temperature environment. In addition, when the blending amount is set to the upper limit value or less, it becomes possible to control the increase in the viscosity of the resin composition, and, consequently, preferable workability can be obtained. In addition, in the invention, in a case in which the (C) (meth)acryl polymer or copolymer has a reactive functional group that can react with a functional group included in the (A) polymer or copolymer of a conjugated diene compound having at least one functional group, it is possible to optimize coating workability using the synergic action of the (A) component and the (C) component and to make the soldering resistance favorable.

In the resin composition of the invention, it is possible to use a filler for the purpose of adjusting workability or supplying conductive property or thermal conductivity. Examples of the filler include metal powder, such as silver powder, gold powder, copper powder, aluminum powder, nickel powder and palladium powder; ceramic powder, such as alumina powder, titania powder, aluminum nitride powder, boron nitride powder and silica powder; macromolecule powder, such as polyethylene powder, polyacrylic acid ester powder, polytetrafluoroethylene powder, polyamide powder, polyurethane powder and polysiloxane powder; and the like. The filler can be used solely, or two or more fillers can also be jointly used in order to reduce the cost of the resin composition. Particularly, in a case in which there is a demand for conductive property and thermal conductivity, silver powder is preferably used. As silver powder generally commercially available as an electronic material, reduced powder, atomized powder and the like can be purchased. However, since there are cases in which a large amount of ionic impurities are included in silver powder for non-electronic material use, attention needs to be paid.

The average particle diameter of the filler is preferably 1 µm to 30 µm. When the average particle diameter is set to the lower limit value or more of the range, it is possible to provide a more preferable viscosity to the resin composition, and to obtain favorable workability. In addition, when the average particle diameter is set to the upper limit value or less of the above range, it is possible to prevent nozzle clogging even in a case in which the resin composition is ejected using a nozzle, and to obtain favorable coating workability.

The shape of the filler is not particularly limited, and may be a flake shape, a spherical shape or the like. For example, in a case in which the filler is silver powder, the filler preferably has a flake shape in order to improve storing property or workability, and, in the case of the filler of non-metal powder, such as silica powder, the filler preferably has a spherical shape in order to prevent damage on the surface of a chip when the chip is stacked. Furthermore, the blending amount of the filler can be approximately adjusted depending on purpose, and, for example, in a case in which silver powder is used, the blending amount is preferably 65 weight% or more and 95 weight% or less in the resin composition, and, in a case in which silica is used, the blending amount is preferably 30 weight% or more and 70 weight% or less in the resin composition. In a case in which silver powder is used, favorable conductive property can be obtained by setting the blending amount of the silver powder to the lower limit value or more of the above range. In addition, when the blending amount of the silver powder is set to the upper limit value or less of the above range, it is possible to make the viscosity of the resin composition more preferable and to obtain favorable workability. Meanwhile, in a case in which silica is used, it is possible to obtain a cured resin composition having a favorable mechanical strength by setting the blending amount of the silica to the lower limit value or more of the above range. In addition, when the blending amount of the silica is set to the upper limit value or less of the above range, it is possible to make the viscosity of the resin composition more preferable and to obtain favorable workability.

Furthermore, in the resin composition of the invention, it is also possible to use additives, such as a coupling agent, a defoamer and a surfactant. The resin composition of the invention can be manufactured by, for example, preliminarily mixing the respective components of the resin composition, then kneading the components using a triple roll, and then defoaming it in a vacuum.

As the method for manufacturing a semiconductor device using the resin composition of the invention, a well-known method can be used. For example, the resin composition is dispense-coated on a predetermined portion on a lead frame or a substrate using a commercially available die bonder, then, a semiconductor element is mounted, and the resin composition is cured by heating. After that, wire bonding is carried out, and transfer molding is carried out using an epoxy resin, thereby manufacturing a semiconductor device. Alternatively, there is a method in which the resin composition is dispensed on the rear surface of a chip, such as a flip chip ball grid array (BGA), sealed using a underfill material after the junction of the flip chip, a heat dissipation member, such as a heat spreader or a lead, is mounted and cured by heating.

### [Examples]

Hereinafter, the invention will be described in detail using examples and comparative examples, but the invention is not limited thereto.

### (Manufacturing of an acryl copolymer 4)

An acrylic oligomer having a hydroxyl value of 20 mgKOH/g and a molecular weight of 11000 (manufactured by Toagosei Co., Ltd., ARUFON UH-2000, an acrylic oligomer having a hydroxyl group obtained through continuous mass polymerization at a high temperature and a high pressure without using a chain transfer catalyst, 110 g), methacrylic acid (reagent grade, 5 g) and toluene (reagent grade, 500 g) were fed into a separable flask, and stirred for 30 minutes under reflux using a Dean-Stark trap, thereby removing moisture. After the solution was cooled to room temperature, a solution obtained by dissolving dicyclohexyl carbodiimide (10 g) in ethyl acetate (50 ml) was added dropwise over 10 minutes under stirring, and then reacted for 6 hours at room temperature. After the reaction, ion-exchange water (50 ml) was added under stirring, thereby precipitating excess dicyclohexyl carbodiimide, and then the solution was stirred for 30 minutes under reflux using the Dean-Stark trap, thereby removing moisture. The solution was cooled to room temperature, then, the reaction liquid was filtered so as to remove the solid content, and liquid-liquid extraction was carried out three times using ion-exchange water of 70°C and two times using ion-exchange water at room temperature. The solvent was removed from a liquid obtained from the re-filtration of a solvent layer using an evaporator and a vacuum dryer, thereby obtaining a product. (The yield was approximately 98%. The product was a liquid phase at room temperature. It was confirmed that the (styrene-equivalent) molecular weight was approximately 12000 from a GPC measurement and the methacrylic acid of the raw material did not remain. The disappearance of the hydroxyl group, the presence of methacrylic groups and the generation of ester bonds were confirmed from the measurement of proton NMR using heavy chloroform. The obtained acryl copolymer 4 was a compound having a molecular weight of 12000 and approximately four methacryloyl goups.)

### [Example 1]

Maleic anhydride-denatured polybutadiene obtained from a reaction between polybutadiene and maleic anhydride (manufactured by Satomer Company, Inc., Ricobond 1731, number-average molecular weight: 5400, acid anhydride equivalent weight 583, hereinafter referred to as stress reducer 1) as the (co)polymer of a conjugated diene compound (A); propoxylated bisphenol A diacrylate (manufactured by Shin-Nakamura Chemical Co., Ltd., NK ESTER A-BPP-3, hereinafter referred to as monomer 1), 1,6-hexanediol dimethacrylate (manufactured by Kyoeisha Chemical Co., Ltd., LIGHT ESTER1,6HX, hereinafter referred to as monomer 2) and isobonyl methacrylate (manufactured by Satomer Company, Inc., LIGHT ESTER 1BX, hereinafter referred to as monomer 3) as the thermosetting resin (B); an acrylic copolymer having a glycidyl group that can react with the maleic anhydride group in the (co)polymer of a conjugated diene compound (A) (manufactured by Toagosei Co., Ltd., ARUFON UG-4010, weight-average molecular weight: 2900, epoxy equivalent weight: 714, hereinafter referred to as acryl copolymer 1) as the (meth)acryl (co)polymer (C); a silane coupling agent having a methacryl group (manufactured by Shin-Etsu Chemical Co., Ltd., KBM-503P, hereinafter referred to as coupling agent 1) and a silane coupling agent having a glycidyl group (manufactured by Shin-Etsu Chemical Co., Ltd., KBM-403E, hereinafter referred to as coupling agent 2) as additives; 1,1-di(tert-butylperoxy)cyclohexane (manufactured by NOF Corporation, PERHEXA CS, hereinafter referred to as polymerization initiator 1) as a polymerization initiator; and flake-form silver powder having an average particle diameter of 3 µm and a maximum particle diameter of 20 µm (hereinafter referred to as silver powder) as a filler were blended as described in Table I, kneaded and defoamed using a triple roll, thereby obtaining a resin composition. After that, the resin composition was evaluated using an evaluation method described below, and the results are described in Table 1. Meanwhile, the blending fractions are weight%.

### [Examples 2 to 8]

Components were blended in the fractions described in Table 1, resin compositions were obtained in the same manner as in Example 1, and then evaluated.
Meanwhile, in Example 2, an acrylic copolymer having a glycidyl group that can react with the maleic anhydride group in the (co)polymer of a conjugated diene compound (A) (manufactured by Toagosei Co., Ltd., ARUFON UG-4035, weight-average molecular weight: 11000, epoxy equivalent weight: 556, hereinafter referred to as acryl copolymer 2) was used as the (meth)acryl (co)polymer (C); in Example 3, an acrylic copolymer having a hydroxyl group that can react with the maleic anhydride group in the (co)polymer of a conjugated diene compound (A) (manufactured by Toagosei Co., Ltd., ARUFON UH-2000, weight-average molecular weight: 11000, hydroxyl group equivalent weight: 2806, hereinafter referred to as acryl copolymer 3) was used as the (meth)acryl (co)polymer (C); in Example 4, the acrylic copolymer 4 having a methacryloyl group that can react with the (meth)acryloyl group in the thermosetting resin (B) was used as the (meth)acryl (co)polymer (C); in Example 5, tetrasulfde ditriethoxysilane (manufactured by Daiso Co., Ltd., CABRUS 4, hereinafter referred to as coupling agent 3) was used as the additive; in Example 6, dicumyl peroxide (manufactured by NOF Corporation, PERCUMYL D, hereinafter referred to as polymerization initiator 2) was used as the polymerization initiator, and spherical silica having an average particle diameter of 0.5 µm (hereinafter referred to as silica) was used as a filler; in Example 7, carboxyl group-denatured polybutadiene (manufactured by Ube Industries, LTD., CTBN-1008SP, number-average molecular weight: 3500, hereinafter referred to as stress reducer 2) was used as the (co)polymer of a conjugated diene compound (A); and, in Example 8, glycidyl group-denatured polybutadiene (manufactured by Nippon Soda Co., LTD., JP-200, number-average molecular weight: 3600, hereinafter referred to as stress reducer 3) was used as the (co)polymer of a conjugated diene compound (A).

### [Comparative Example I to 5]

Components were blended in the fractions described in Table 1, resin compositions were obtained in the same manner as in Example 1, and then evaluated.
Meanwhile, in Comparative Examples 3 to 5, a non-functional acrylic copolymer that does not react with any functional groups included in the (co)polymer of a conjugated diene compound (A) or the thermosetting resin (B) (manufactured by Toagosei Co., Ltd., ARUFON UP-1000, weight-average molecular weight: 3000, hereinafter acryl copolymer 5) was used as the (meth)acryl (co)polymer.

### (Evaluation method)

Viscosity: a value at 25°C and 2.5 rpm was measured using an E-type viscometer (3° cone) immediately after the manufacturing of the resin composition. The resin compositions having a value of the viscosity of 20±10 Pa·s were evaluated to be Pass. The unit of the viscosity is Pa·s.
Tapping test: the resin composition was coated at 1000 points (the coating amount: approximately 0.2 mg/point) using a tapping tester (manufactured by Musashi Engineering, Inc., SHOTMASTER-300) and a 22G single nozzle (inner diameter: 0.47 mm). After that, the coated tap points were observed from directly above, and the number of ineffective tapping (points at which the resin composition was not coated) and the number of failed thread cutting (points at which thread cutting was poor and the coated resin composition collapsed outside during the coating) were measured. A case in which the total number of ineffective tapping and failed thread cutting was less than 5% was evaluated to be Pass. The unit of the tapping test is %.

Reflow resistance: a silicon chip (7x7 mm, thickness 0.35 mm) was cured at 175°C for 15 minutes (lamp up 30 minutes) so as to be attached to a 0.3 mm-thick BT substrate (BT resin-used substrate made of a cyanate monomer, an oligomer thereof and bismaleimide) using the resin composition described in Table 1. The die-bonded substrate was sealed into a 5.5×6.6×1.0 mm panel shape using a semiconductor-sealing epoxy resin composition (manufactured by Sumitomo Bakelite Co., Ltd., EME-G760L). After that, post mold curing was carried out at 175°C for 4 hours, and IR reflow was made to flow once in a non-hygroscopic state. After that, the substrate was individualized into a body size of 10×12 mm using a dicing saw, thereby obtaining a semiconductor device (MAPBGA). In addition, a silicon chip (5 × 5 mm, thickness 0.35 mm) was cured at 175°C for 30 minutes (lamp up 30 minutes) so as to be attached to a lead frame (silver ring-plated copper frame) in the same manner. The die-bonded lead substrate was sealed into a package size of 14×20×2.0 mm panel shape using a semiconductor-sealing epoxy resin composition (manufactured by Sumitomo Bakelite Co., Ltd., EME-G700QB). After that, post mold curing was carried out at 175°C for 4 hours, and a semiconductor device (QFP) was obtained.
The obtained semiconductor device was subjected to a moisture-absorbing treatment at 85°C and a relative humidity of 85% for 72 hours. After that, an IR reflow treatment (260°C, 10 seconds, three-time reflow) was carried out, and the degree of detachment in the treated semiconductor device was measured using an ultrasonic flaw detector (transmission type). A case in which the detached area in the die attached portion was less than 10% was evaluated to be Pass. The unit of the detached area is %.
Meanwhile, MAPBGA in Table I is the name of the kind of a semiconductor device manufactured using the BT substrate, and QFP is the name of the kind of a semiconductor device manufactured using the lead frame.

**[Table 1]**

| | | Examples | | | | | | | | Comparative Examples | | | | |
|---|---|---|---|---|---|---|---|---|---|---|---|---|---|---|
| | | 1 | 2 | 3 | 4 | 5 | 6 | 7 | 8 | 1 | 2 | 3 | 4 | 5 |
| Reaction partner (A) | | ○ | ○ | ○ | ○ | ○ | ○ | ○ | ○ | | | | | |
| (B) | | | | | ○ | | | | | | | | | |
| (C) | | ○ | ○ | ○ | | ○ | ○ | ○ | ○ | | | | | |
| Silver powder | | 75.00 | 75.00 | 75.00 | 75.00 | 75.00 | | 75.00 | 75.00 | 75.00 | 75.00 | 75.00 | 75.00 | |
| Silica | | | | | | | 5000 | | | | | | | 50.00 |
| Stress reducer 1 | | 4.10 | 4.10 | 4.10 | 2.23 | 2.08 | 8.20 | | | 4.10 | 6.39 | 4.10 | 2.08 | 8.20 |
| Stress reducer 2 | | | | | | | | 4.10 | | | | | | |
| Stress reducer 3 | | | | | | | | | 4.10 | | | | | |
| Acryl copolymer 1 | | 5.12 | | | | 7.29 | 10.25 | 5.12 | 5.12 | | | | | |
| Acryl copolymer 2 | | | 4.10 | | | | | | | | | | | |
| Acryl copolymer 3 | | | | 5.12 | | | | | | | | | | |
| Acryl copolymer 4 | | | | | 3.35 | | | | | | | | | |
| Acryl copolymer 5 | | | | | | | | | | | | 5.12 | 729 | 10.25 |
| Monomer 1 | | 7.17 | 6.15 | 10.25 | 11.16 | 10.42 | 1639 | 7.17 | 7.17 | 11.27 | 10.04 | 7.17 | 10.42 | 16.39 |
| Monomer 2 | | 6.15 | 8.20 | 3.07 | 5.58 | 2.08 | 8.20 | 6.15 | 6.15 | 5.12 | 4.56 | 6.15 | 2.08 | 8.20 |
| Monomer 3 | | 2.05 | 2.05 | 2.05 | 2.23 | 2.08 | 6.15 | 2.05 | 2.05 | 4.10 | 3.65 | 2.05 | 2.08 | 6.15 |
| Coupling agent 1 | | 0.10 | 0.10 | 0.10 | 0.11 | 0.10 | 0.20 | 0.10 | 0.10 | 0.10 | 0.09 | 0.10 | 0.10 | 0.20 |
| Coupling agent 2 | | 0.10 | 0.10 | 0.10 | 0.11 | 0.10 | 0.20 | 0.10 | 0.10 | 0.10 | 0.09 | 0.10 | 0.10 | 0.20 |
| Coupling agent 3 | | | | | | 063 | | | | | | | 0.63 | |
| Polymerization initiator 1 | | 0.20 | 0.20 | 0.20 | 0.22 | 0.21 | | 020 | 020 | 0.20 | 0.18 | 0.20 | 0.21 | |
| Polymerization initiator 2 | | | | | | | 0.41 | | | | | | | 0.41 |
| | | | | | | | | | | | | | | |
| Viscosity | Pa·s | 20 | 21 | 20 | 19 | 19 | 15 | 20 | 20 | 22 | 31 | 21 | 17 | 20 |
| Tapping test | % | 0 | 0 | 0 | 4 | 0 | 0 | 0 | 0 | 3 | 22 | 4 | 3 | 2 |
| Reflow resistance (kind of semiconductor device) | | MAPBGA | MAPBGA | MAPBGA | MAPBGA | QFP | MAPBGA | MAPBGA | MAPBGA | MAPBGA | MAPBGA | MAPBGA | QFP | MAPBGA |
| Reflow resistance (detached area) | % | <10 | <10 | <10 | <10 | <10 | <10 | <10 | <10 | >30 | <10 | >30 | >30 | >30 |
| General evaluation | | ○ | ○ | ○ | ○ | ○ | ○ | ○ | ○ | X | X | X | X | X |

### Industrial Applicability

When the resin composition obtained using the invention is used, since coating workability becomes favorable, no problem occurs in a die bonding step, and, furthermore, it is possible to obtain a semiconductor device that is excellent in terms of soldering crack resistance even in a high temperature environment caused by an IR reflow treatment or the like.

## Claims

1. A resin composition comprising:
(A) a polymer or copolymer of a conjugated diene compound having at least one functional group;
(B) a thermosetting resin; and
(C) a (meth)acryl polymer or copolymer,
wherein the (C) (meth)acryl polymer or copolymer has a reactive functional group that can react with other reactive groups.

2. The resin composition according to Claim 1,
wherein the (C) (meth)acryl polymer or copolymer has a reactive functional group that can react with the functional group included in the (A) polymer or copolymer of a conjugated diene compound having at least one functional group.

3. The resin composition according to Claim 2,
wherein the (A) polymer or copolymer of a conjugated diene compound having at least one functional group is a polymer or a copolymer of butadiene.

4. The resin composition according to Claim 2,
wherein the functional group included in the (A) polymer or copolymer of a conjugated diene compound having at least one functional group is at least one selected from a group consisting of a vinyl group, a (meth)allyl group, a (meth)acryloyl group, an epoxy group, a carboxyl group, a hydroxyl group and a maleic anhydride group.

5. The resin composition according to Claim 2,
wherein the (B) thermosetting resin is at least one selected from a group consisting of a cyanate resin, an epoxy resin, an acryl resin and a maleimide resin.

6. The resin composition according to any one of claims 2 to 5,
wherein the reactive function group of the (C) (meth)acryl polymer or copolymer is at least one selected from a group consisting of a vinyl group, a (meth)allyl group, a (meth)acryloyl group, a maleimide group, an epoxy group, a carboxyl group and a hydroxyl group.

7. The resin composition according to Claim 2,
wherein the (A) polymer or copolymer of a conjugated diene compound having at least one functional group is included at 1 weight% to 20 weight%, and the (C) (meth)acryl polymer or copolymer is included at 0.5 weight% to 25 weight% with respect to a total weight of the resin composition.

8. The resin composition according to Claim 1,
wherein the (C) (meth)acryl polymer or copolymer has a reactive functional group that can react with the functional group included in the (B) thermosetting resin.

9. The resin composition according to Claim 8,
wherein which the (A) polymer or copolymer of a conjugated diene compound having at least one functional group is a polymer or a copolymer of butadiene.

10. The resin composition according to Claim 8,
wherein the functional group included in the (A) polymer or copolymer of a conjugated diene compound having at least one functional group is at least one selected from a group consisting of a vinyl group, a (meth)allyl group, a (meth)acryloyl group, an epoxy group, a carboxyl group, a hydroxyl group and a maleic anhydride group.

11. The resin composition according to Claim 8,
wherein the (B) thermosetting resin is at least one selected from a group consisting of a cyanate resin, an epoxy resin, an acryl resin and a maleimide resin.

12. The resin composition according to any one of Claims 8 to 11,
wherein the reactive function group of the (C) (meth)acryl polymer or copolymer is at least one selected from a group consisting of a vinyl group, a (meth)allyl group, a (meth)acryloyl group, a maleimide group, an epoxy group, a carboxyl group and a hydroxyl group.

13. The resin composition according to Claim 8,
wherein the (A) polymer or copolymer of a conjugated diene compound having at least one functional group is included at 1 weight% to 20 weight%, and the (C) component is included at 0.5 weight% to 25 weight% with respect to a total weight of the resin composition.

14. A semiconductor device manufactured using the resin composition according to any one of Claims 1, 2 and 8 as a die attach material or an adhesive material for a heat dissipation member.
